(19) Europäisches Patentamt
European Patent Office
Office européen des brevets

(11) **EP 2 148 374 A1**

(12) **EUROPEAN PATENT APPLICATION**

(43) Date of publication:
**27.01.2010 Bulletin 2010/04**

(51) Int Cl.:
*H01L 29/775* (2006.01)   *H01L 29/08* (2006.01)
*H01L 29/66* (2006.01)   *H01L 29/78* (2006.01)

(21) Application number: **08104843.1**

(22) Date of filing: **23.07.2008**

| | |
|---|---|
| (84) Designated Contracting States:<br>**AT BE BG CH CY CZ DE DK EE ES FI FR GB GR HR HU IE IS IT LI LT LU LV MC MT NL NO PL PT RO SE SI SK TR**<br>Designated Extension States:<br>**AL BA MK RS**<br><br>(71) Applicant: **University College Cork-National University of Ireland, Cork Cork (IE)** | (72) Inventors:<br>• **Colinge, Jean-Pierre Cork City (IE)**<br>• **Afzalian, Aryan Co. Cork (IE)**<br><br>(74) Representative: **Lucey, Michael PURDYLUCEY Intellectual Property Suite 138-139 The Chapel Building Mary's Abbey Dublin 7 (IE)** |

(54) **A tunnel nanowire transistor**

(57) The invention provides a new type of transistor comprising a nanowire structure adapted to provide a tunnel barrier such that an applied gate voltage causes a current to oscillate, as the gate voltage is increased, to provide a region of negative transconductance. The device presents oscillations of current as the gate voltage is increased, typically when the cross section of the wire is smaller than 10nm. The sub-threshold slope of the current is larger than 60 mV/decade but can locally reach values smaller than 60 mV/decade in devices with small cross sections. The new transistor has applications in ultra fast switches operating at a very low voltage and in the area of memory devices in the nano-scale.

**Figure 1A**

Z         X

Tunnel barrier

| Gate 1 ($V_{G1}$=0) | |
|---|---|
| Source | Channel | Drain |
| Gate 1 ($V_{G1}$=0) | |

y

**Figure 1B**

Z         X

Tunnel barrier

| Gate 1 ($V_{G1}$=0) | |
|---|---|
| Drain | Channel | Source |
| Gate 1 ($V_{G1}$=0) | |

y

**Figure 1C**

**Description**

**Field of the Invention**

The invention relates to transistors and Multi-Gate Field-Effect Transistors. In particular the invention relates to nanowire tunnelling transistors.

**Background to the Invention**

Multi-Gate Field-Effect Transistors (MuGFETs) are increasingly gaining popularity as they allow one to reduce the dimensions of the Metal-Oxide-Semiconductor (MOS) transistor below what classical planar CMOS technology is capable of, for example as proposed in a book entitled 'FinFETs and Other Multi-Gate Transistors', J.P. Colinge (Ed.) Springer (2007) November 2007 (ISBN: 978-0-387-71751-7).

A MuGFET is basically a silicon nanowire with a gate insulator and a gate electrode wrapped around it. This gate configuration allows for an optimized control of the transistor's electrostatics by the gate electrode, which greatly reduces short-channel effects. Fully functional MuGFETs with a silicon nanowire cross-section smaller than 5 nm have been reported in the literature, for example as reported in a paper published by N. Singh, A. Agarwal, L.K. Bera, T.Y. Liow, R. Yang, S.C. Rustagi, C.H. Tung, R. Kumar, G.Q. Lo, Balasubramanian, D.L. Kwong, IEEE Electron Device Letters, 27-5, 383 (2006). One-dimensional transport with confinement in the two other directions results in the formation of energy subbands and a Density of States (DoS) that presents a series of peaks, when plotted as a function of energy, as shown in "Quantum-Mechanical Effects in Trigate SOI MOSFETs", J.P. Colinge, J. C. Alderman , W. Xiong, and C. R. Cleavelin, IEEE Transactions on Electron Devices, Vol. 53, no 5, pp. 1131-1136, 2006.

As the channel length of metal-oxide-semiconductor field-effect transistors (MOSFET) scales into the nanometer regime, short channel effects become more and more significant. Consequently effective gate control is required for a nanoscale MOSFET to achieve good device performance. For this reason, silicon nanowires which allow multigate, "gate-all-around" or "wrap-around" gate transistors are highly desirable in the industry.

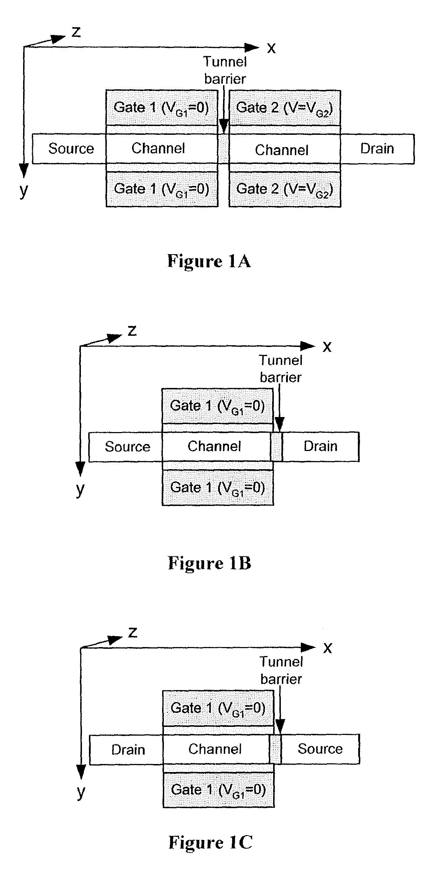

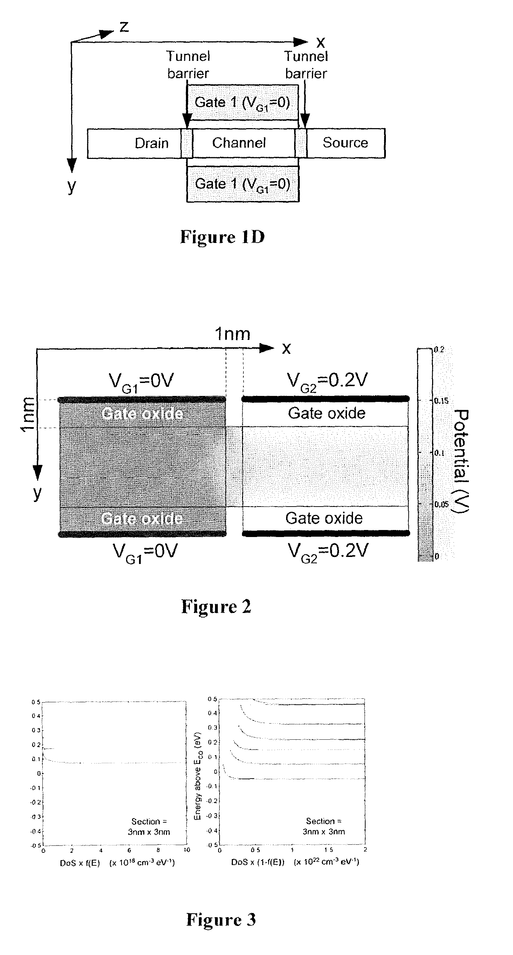

PCT Patent Publication number WO2007/086009 entitled 'NANOWIRE TUNNELING TRANSISTOR' discloses a transistor comprising of a nanowire having a source and a drain separated by a "channel" region. A tunnel barrier is formed in the channel region or at the interface between the channel region and one of the source and the drain, or both (Figures 1A, 1B, 1C and 1D). One (Figures 1B, 1C and 1D) or two (Figure 1A) gate electrode(s) is (are) provided in the vicinity of the tunnel barrier such that the potential drop across the potential barrier can be modulated by applying an appropriate voltage to the gate electrode(s). Another type of transistor structure is proposed by Santanu Mahapatra and Nayan Patel, "An n-type tunnel FET device with strained SiGe layer at source", disclosed in Indian patent application Number: 02057/CHE/2007, September 2007.

All the proposed devices to date are based on either a reverse PN junction (PN Tunnel junction, also known as Tunnel Diode or Esaki junction or Esaki diode - 1973 Nobel prize) or the formation of tunnel barriers using heterojunctions. All the proposed devices use tunnelling of electrons from the valence band to the conduction band (band-to-band tunnelling). Devices based on an Esaki junction are non symmetrical (there is an anode and a cathode, unlike regular MOS transistors which have a source and a drain). A problem with the formation of a heterojunction requires them either to have a vertical or non-planar transistor.

There is therefore a need to provide a transistor device structure to overcome the above mentioned problems.

**Summary of the Invention**

According to the present invention there is provided, as set out in the appended claims, a transistor comprising a nanowire structure adapted to provide a tunnel barrier such that an applied gate voltage causes a current to oscillate, as the gate voltage is varied to provide a region of negative transconductance.

The invention provides a novel construction of a transistor, based on nanowire technology. The inventors of the present application found that by controlling the gate voltage of a nanowire transistor and using a tunnel barrier produced oscialltions or spikes of current for transistor corss-sections of less than 10nm. The nanowire transistor, according to the present invention, makes use of the current oscillations (spikes) and regions of negative transconductance for structures with cross sections below 10nm. The transconductance is the derivative (i.e. the slope) if the current as a function of gate voltage. When the current increases, the slope (transconductance) is positive. When the current decreases, the transconducance is negative.

In the new invention, tunnelling is from subbands in the conduction band to subbands in the conduction band on the other side of the tunnel barrier (intraband tunnelling). The existence of such subbands has been shown experimentally ("Low-Temperature Electron Mobility in Trigate SOI MOSFETs", Colinge, J.-P.; Quinn, A.J.; Floyd, L.; Redmond, G.; Alderman, J.C.; Xiong, W.; Cleavelin, C.R.; Schulz, T.; Schruefer, K.; Knoblinger, G.; Patruno, P., IEEE Electron Device Letters, Vol. 27, no. 2 , pp. 120-122, 2006 and "Room-Temperature Low-Dimensional Effects in Pi-Gate SOI MOSFETs", Colinge, J.P.; Xiong, W.; Cleavelin, C.R.; Schulz, T.; Schrüfer, K.; Matthews, K.; Patruno, P., Electron Device Letters, IEEE, Volume 27, Issue 9, pp. 775-777, 2006).

The application of the negative transconductance region provides for ultra-fast switches on a nano-scale and only requires very low voltages for operation (below 0.7V). In addtition because the transistor can be coupled with a negative resistance device delivers a memory cell then there are also memory storage applications possible on a nano-scale. The current below threshold presents regions where the subthreshold slope (SS) is smaller than the classical limit (classical limit is SS=kT/q log(10)). This opens up the possibility of making devices that can operate at very low supply voltage. In the latter expression of SS, k is the Boltzmann constant, q is the electrical charge of an electron (in absolute value), T is the temperature (in Kelvins), and log(10) is the natural logarithm of number ten. The SS is expressed in mV per decade.

It will be appreciated that the nanowire transistor has applications for ultra-low volatage operation. The transistors, according to the present invention, are useable with a supply voltage that is lower than current standards. The roadmap for such voltage supply has seen a steady reduction from 9V to 5V to 3.3V and now to 1.1V. The next step on this roadmap is 0.7V. It is desirable to use a lower voltage supply in industry as this means lower power consumption in transistor devices.

Ideally, the tunnel barrier is provided in the channel of the transistor such that two gates are formed, each gate adapted to apply a different potential. Alternatively, a single gate can be used, and the tunnel barrier is formed at the interface between the source and the channel region, the drain and the channel region, or both (in which case there are two barriers).

Suitably, the current oscillations, in response to said increasing voltage, are provided if the cross section of the wire is smaller than approximately 10nm. Ideally, the dimensions of the nanowire are in the range of 3-5nm.

In one embodiment the transistor comprises N type of doping only. Suitably, electron transitions from one side of the tunnel barrier to the other side of the tunnel barrier is controlled by the application of the gate voltage. In other embodiments, the source, channel and drain dopings can be NPN, NIN, PNP, PPP or PIP, respectively (i-intrinsic or undoped). The device of the present invention can be NPN (N-source, P-channel and N-drain) or N-N⁻N (lightly doped N-channel) or NIN (Intrinsic (undoped) channel), or PNP (P-channel device with P-type source and drain and N-type channel doping), etc.

In another embodiment of the present invention the transistor is coupled with a positive resistance device to provide a memory cell. In other words the device provides the negative resistance for making a memory element based on the combination of a positive resistance and a negative resistance.

Suitably, the tunnel barrier comprises a thin insulator layer. In another embodiment the tunnel barrier comprises a constriction of the nanowire diameter. In another embodiment the tunnel barrier comprises a layer where the degree of crystallinity of the semiconductor is modified or where the surface of the semiconductor is locally influenced by chemical agents.

Suitably the invention provides current oscillations provide reach values smaller than 60 mV/decade (at T=300K or, in general, kT/q log(10) at any temperature, in a structure with a cross section size of less than 10nm.

## Brief Description of the Drawings

The invention will be more clearly understood from the following description of an embodiment thereof, given by way of example only, with reference to the accompanying drawings, in which:-

Figures 1A-1D: illustrates a schematic cross section of the tunnel nanowire transistor according to a different aspects of the present invention;

Figure 2: illustrates a potential distribution for Vg2=0.2V in the cross section of the transistor of with a 3nmx3nm cross section corresponding with the device presented in Figure 1A;

Figure 3: is a graphical representation of a product of the DoS by $f_{FD}$ on the source side of the tunnel barrier (left) and Product of the DoS by $1-f_{FD}$ on the drain side of the barrier (right) for $V_G$=200mV corresponding with the device presented in Figure 1A;

Figure 4: illustrates a graphical representation of a drain current as a function of gate voltage in devices with different cross sections; and

Figure 5: illustrates a graphical representation of a drain current (log scale) as a function of gate voltage in devices with different cross sections.

## Detailed Description of the Drawings

Referring to the drawings, an embodiment of the transistor device, according to the present invention, is shown in Figures 1 and 2, wherein a tunnel barrier in the channel region of a nanowire transistor is introduced. Different possible embodiments are shown. Figure 1A corresponds to a two-gate device with the tunnel barrier in the channel between the gates. Figures 1B and 1C show a single-gate device with the barrier at the edge of either the source or the drain, and Figure 1D shows a device with barriers on both sides of the gate. A tunnel barrier is introduced in the channel of the transistor such that different potentials can be applied to the two gates, shown in Figure 1A. In Figures 1B, 1C and 1D, a variable potential is applied to a single gate, creating a variable potential variation across the tunnel barrier(s).

One should bear in mind that Figure 1 shows a cross section of the device which does not show that the gate (s) is/are wrapped along all the edges of the nanowire (i.e. top, bottom, left and right edges). As an alternative, the gate can be wrapped along less than four sides (e.g. three sides as in the case of trigate, pi-gate or omega-gate configurations).

It will be appreciated that the configuration of the device of Figure 1A is to illustrate one preferred embodiment of the invention, but other structures are possible, for example using a single gate electrode and a tunnel barrier under the edge of the gate, at the source side. The tunnel barrier can consist of a thin insulator layer or a constriction of the nanowire diameter, see X. Tang, X. Baie, J.P. Colinge, F. Van de Wiele and V. Bayot, Electrochemical Society Proceedings, 2001-3, 415 (2001) for using constriction to form tunnel barriers.

The device according to Figure 1 was simulated using the two-dimensional Poisson-Schrödinger solver, for example as described in J.P. Colinge, J. C. Alderman , W. Xiong, and C. R. Cleavelin, IEEE Transactions on Electron Devices, 53-5, 1131 (2006). This solver can produce the DoS in nanowire transistors with arbitrary cross section and gate structure. The density of states a function of energy, $DoS(E)$ is calculated for $V_G=0$ at the source side of the device (Gate 1), while it is calculated for different gate voltage values, $V_G$, at the drain side (Gate 2).

The density of states $DoS(E)$ multiplied by the Fermi-Dirac distribution $f_{FD}(E)$ gives the distribution of occupied states on the source side of the tunnel barrier, while the product of the $DoS(E)$ by $1-f_{FD}(E)$ yields the distribution of available states on the drain side. It is worthwhile noting that the variation of shape of the DoS with gate voltage is taken into account in the simulation, and that the density of states in any cross section perpendicular to the x-direction is independent of $y$ or $z$.

Figures 2 and 3 show a 2D simulation of the potential distribution in a device with a silicon cross section of $y$=3nm and $z$=3nm, a gate oxide thickness of 1nm and a tunnel barrier thickness of 1nm.

The applied gate voltage $V_{G2}$ is 0.2V, and the channel doping concentration is $10^{17}$ cm$^{-3}$ (donors). Because the device has a gate-all around structure, the natural length, or propagation of the electric fields in the x-direction, is very small, as shown in a paper published by Chi-Woo Lee, Se-Re-Na Yun, Chong-Gun Yu, Jong-Tae Park, J.P. Colinge, Solid-State Electronics, 51-3, 505 (2007).

As a result, the band bending in the x-direction on both sides of the tunnel barrier extends for only a fraction of a nanometer before reaching the largest part of the nanowire, where the potential is independent of x.

Assuming a small value of drain voltage and a constant transmission coefficient through the tunnel barrier, T, and assuming the channel resistance is negligible, the tunnel current, $I_D(V_G)$, is proportional to:

$$I_D(V_G) \approx \tau \int DoS(E,V_G=0) \times f_{FD}(E,V_G=0) \times DoS(E,V_G) \times \left(1 - f_{FD}(E,V_G)\right) dE \quad \text{(Eqn. 1)}$$

where $f_{FD}$ is the Fermi-Dirac distribution. The product $DoS(E,V_G=0) \times f_{FD}(E,V_G=0)$ represents the conduction-band states populated with electrons on the source side of the tunnel barrier, and the product $DoS(E,V_G) \times (1-f_{FD}(E,V_G))$ represents the empty states on the drain side.

Figure 3 shows these two products, for a value of $V_G$ = 200mV, and for a silicon nanowire MuGFET with a 3nmx3nm square cross section. The present invention found that as the gate voltage is increased, the right curve of the graph essentially shifts downward, and the resulting drain current is calculated using Eqn. (1).

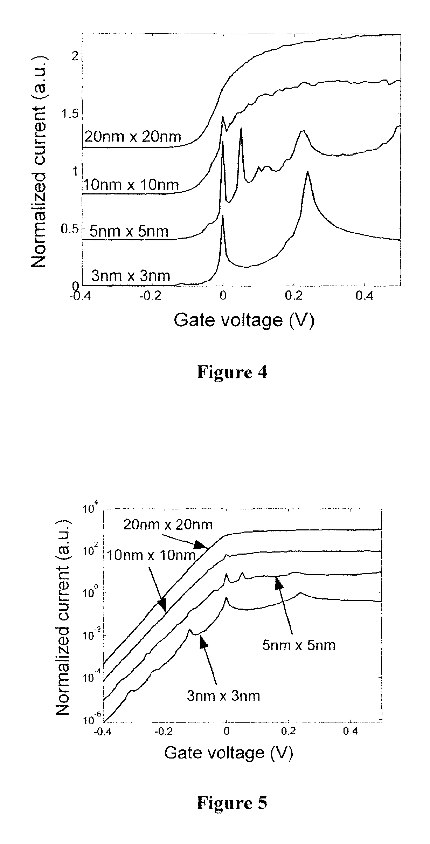

Figure 4 shows the current calculated at T=300K for devices with square cross sections of 3nmx3nm, 5nm×5nm, 10nm×10nm and 20nmx20nm. Accumulation-mode devices are selected because they deliver a higher current at $V_G$=0 than inversion-mode devices. In the simulations, a channel doping concentration of $10^{17}$ cm$^{-3}$ (donors) was used, which places the Fermi level 160 mV below the minimum of the conduction band under flatband bias conditions.

The current is normalized for each device and the different curves are shifted upward in order to put them on a single figure. In reality, the current is basically equal to zero for all devices at $V_G$= -0.4V. The devices with the smallest cross sections present a series of current peaks followed by negative transconductance regions, i.e. current oscillations. It was found that device sizes under 5nm provide for particularly sharp regions of negative transconductance that can be used for transistor applications. Negative transconductance can be used to create memory elements (a memory element can be created based on a negative resistance device and a regular transistor that has a positive transconductance) or a resistor. In the subthreshold region, the regions with reduced subthreshold slope can be used for low-supply voltage operation, as less gate voltage variation is needed to switch the device from the OFF state to the ON state than in a regular device with higher value of subthreshold slope.

Each peak shown in Figure 4 corresponds to a value of $V_G$ for which peaks of $DoS(E,V_G=0) \times f_{FD}(E,V_G=0)$ have the same energy as peaks of $DoS(E,V_G) \times (1-f_{FD}(E,V_G))$. These oscillations vanish out in wider devices and are completely absent in the device with a 20nm cross section.

Figure 5 shows the drain current on a logarithmic scale. All the devices have an average sub-threshold slope slightly larger than $\dfrac{kT}{q}\ln(10)$ or 60 mV/decade at T=300K, but the devices with the smallest cross-sections can locally produce a sub-60mV/decade slope, and even a negative sub-threshold slope.

In the sub-threshold region, the space between the peaks roughly corresponds to the spacing between the DoS peaks, for example approximately by 100 mV for the 3nmx3nm device in Figure 5 because $d\Phi_2/dV_{G2}$ is roughly equal to unity, where $\Phi_2$ is the potential in the drain-side section of the nanowire channel region(i.e. the body factor is equal to 1).

Above threshold, however, the build-up of an accumulation electron charge in the nanowire increases the potential drop in the gate oxide, and, as a result, $d\Phi_2/dV_{G2} < 1$. This increases the spacing between the current peaks above threshold, as disclosed in a paper by J. P. Colinge, X. Baie, V. Bayot, IEEE Electron Device Letters, 15-6, 193 (1994).

It will be appreciated that the device of the present invention can be symmetrical, like regular MOS transistors with a source and a drain. The proposed device is planar and the tunnel barrier is introduced by either creating a constriction in the semiconductor nanowire, introduction of defects in the nanowire, or introducing an insulator barrier in the nanowire.

The transformation of the device, illustrated in the Figures, into a Tunnel Nanowire Transistor according to the invention requires the formation of a tunnel barrier. One option to form the tunnel barrier is to amorphise the source and drain using ion implantation and anneal the device in such a way that a defect region (e.g. a grain boundary is created at the interface between the channel and the source or drain device in Figure 1D). Oxidation/etching can be used to create a constriction at both source and drain sides of the channel, thereby creating barriers at the interface between the channel and the source or drain device, for example as shown in Figure 1D.

It will be appreciated that to fabricate the device in Figure 1A one can use atomic-force-microscopy enhanced oxidation the create an insulating oxide in the middle of the channel which would both separate the single gate into two gates and create an oxide tunnel barrier in the nanowire. The device in Figure 1A can be fabricated using the double-poly gate MOS structure. A constriction in the nanowire between the gates could be produced as a part of the gate oxidation process.

The embodiments in the invention described with reference to the drawings can comprise a computer apparatus and/or processes performed in a computer apparatus to fabricate the transistor according to the invention. However, the invention also extends to computer programs, particularly computer programs stored on or in a carrier adapted to control the process for bringing the invention into practice. The program may be in the form of source code, object code, or a code intermediate source and object code, such as in partially compiled form or in any other form suitable for use in the implementation of the method according to the invention. The carrier may comprise a storage medium such as ROM, e.g. CD ROM, or magnetic recording medium, e.g. a floppy disk or hard disk. The carrier may be an electrical or optical signal which may be transmitted via an electrical or an optical cable or by radio or other means.

The invention is not limited to the embodiments hereinbefore described but may be varied in both construction and detail.

## Claims

1. A transistor comprising a nanowire structure adapted to include a tunnel barrier such that an applied gate voltage causes a current to oscillate, as the gate voltage is varied, to provide a region of negative transconductance.

2. The transistor of claim 1 wherein the tunnel barrier is provided in the channel of the transistor such that two gates are formed, each gate adapted to apply a different potential.

3. The transistor of any preceding claim wherein the tunnel barrier is provided between an edge of a gate and at a source side of said transistor or at drain side or on both sides.

4. The transistor of any preceding claim wherein said current oscillations, in response to said increasing voltage, are provided if the cross section of the wire is smaller than approximately 10nm.

5. The transistor of claim 4 wherein the dimensions of the nanowire are in the range of 3-5nm.

6. The transistor of any preceding claim wherein the transistor comprises N type of doping only.

7. The transistor of any preceding claim wherein electron transitions from one side of the tunnel barrier to the other side of the tunnel barrier is controlled by the application of said gate voltage.

8. The transistor of any preceding claim wherein the transistor is coupled with a positive resistance device to provide a memory cell.

9. The transistor of any preceding claim wherein the tunnel barrier comprises a thin insulator layer.

10. The transistor of any preceding claim wherein the tunnel barrier comprises a constriction of the nanowire diameter.

11. The transistor of any preceding claim wherein the current oscillations provide subthreshold values smaller than 60 mV/decade in a structure with a cross section size of less than 10nm at room temperature.

12. The transistor of claim 11 wherein the subthreshold value is smaller than kT/d log(10) at any temperature.

13. The transistor of any preceding claim wherein the gate voltage is increased to provide the region of negative transconductance.

14. A fabrication process comprising steps to produce the transistor of any of Claims 1 to 13.

15. A computer program comprising program instructions for causing a computer to control the fabrication process of claim 14.

**Figure 1A**

**Figure 1B**

**Figure 1C**

Figure 1D

Figure 2

Figure 3

**Figure 4**

**Figure 5**

Europäisches
Patentamt

European
Patent Office

Office européen
des brevets

# EUROPEAN SEARCH REPORT

Application Number

EP 08 10 4843

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2006/135336 A (QUNANO AB [SE]; WERNERSSON LARS-ERIK [SE]; BRYLLERT TOMAS [SE]; LIND E) 21 December 2006 (2006-12-21) * page 12, lines 1-25; figures 6,7 * ----- | 1,3-15 | INV. H01L29/775 H01L29/08 H01L29/66 ADD. H01L29/78 |
| X | US 5 972 744 A (MORIMOTO KIYOSHI [JP] ET AL) 26 October 1999 (1999-10-26) * figures 1a,1b,1c; example 1 * ----- | 1,3-8, 11-15 | |
| X | WO 2007/086009 A (NXP BV [NL]; HURKX FRED [NL]; AGARWAL PRABHAT [BE]) 2 August 2007 (2007-08-02) * page 4, line 32 - page 8, line 6; figure 4 * ----- | 1,3-8, 11-15 | |
| X | WO 02/084757 A (INFINEON TECHNOLOGIES AG [DE]; HOFMANN FRANZ [DE]; LUYKEN RICHARD JOHA) 24 October 2002 (2002-10-24) * page 11, line 13 - page 13, line 5; figure 4 * ----- | 1,3-8, 11-15 | |
| X | EP 1 901 354 A (IMEC INTER UNI MICRO ELECTR [BE]; UNIV LEUVEN KATH [BE]) 19 March 2008 (2008-03-19) * abstract; figures 4,5,9 * ----- | 1-5,7,8, 11-15 | TECHNICAL FIELDS SEARCHED (IPC) H01L |
| A | KONSTANTIN K LIKHAREV: "Single-Electron Devices and Their Applications" PROCEEDINGS OF THE IEEE, IEEE. NEW YORK, US, vol. 87, no. 4, 1 April 1999 (1999-04-01), XP011044189 ISSN: 0018-9219 * figures 7,8,11,12; table 1 * ----- | 9 | |

The present search report has been drawn up for all claims

| Place of search | Date of completion of the search | Examiner |
|---|---|---|
| Munich | 17 December 2008 | Dauw, Xavier |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 2 148 374 A1

**ANNEX TO THE EUROPEAN SEARCH REPORT
ON EUROPEAN PATENT APPLICATION NO.**

EP 08 10 4843

This annex lists the patent family members relating to the patent documents cited in the above-mentioned European search report.
The members are as contained in the European Patent Office EDP file on
The European Patent Office is in no way liable for these particulars which are merely given for the purpose of information.

17-12-2008

| Patent document cited in search report | | Publication date | Patent family member(s) | | Publication date |
|---|---|---|---|---|---|
| WO 2006135336 | A | 21-12-2006 | AU | 2006258261 A1 | 21-12-2006 |
| | | | CN | 101273459 A | 24-09-2008 |
| | | | EP | 1891679 A1 | 27-02-2008 |
| | | | KR | 20080025147 A | 19-03-2008 |
| | | | WO | 2006135337 A1 | 21-12-2006 |
| US 5972744 | A | 26-10-1999 | NONE | | |
| WO 2007086009 | A | 02-08-2007 | EP | 1979946 A1 | 15-10-2008 |
| WO 02084757 | A | 24-10-2002 | DE | 10118405 A1 | 24-10-2002 |
| | | | EP | 1378017 A1 | 07-01-2004 |
| | | | JP | 2004532523 T | 21-10-2004 |
| | | | US | 2004214786 A1 | 28-10-2004 |
| EP 1901354 | A | 19-03-2008 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2007086009 A

- IN 02057CHE2007

### Non-patent literature cited in the description

- FinFETs and Other Multi-Gate Transistors. Springer, November 2007
- **N. Singh ; A. Agarwal ; L.K. Bera ; T.Y. Liow ; R. Yang ; S.C. Rustagi ; C.H. Tung ; R. Kumar ; G.Q. Lo ; Balasubramanian, D.L. Kwong.** *IEEE Electron Device Letters,* 2006, vol. 27-5, 383
- **J.P. Colinge ; J. C. Alderman ; W. Xiong ; C. R. Cleavelin.** Quantum-Mechanical Effects in Trigate SOI MOSFETs. *IEEE Transactions on Electron Devices,* 2006, vol. 53 (5), 1131-1136
- **Colinge, J.-P. ; Quinn, A.J. ; Floyd, L. ; Redmond, G. ; Alderman, J.C. ; Xiong, W. ; Cleavelin, C.R. ; Schulz, T. ; Schruefer, K. ; Knoblinger, G.** Low-Temperature Electron Mobility in Trigate SOI MOSFETs. *IEEE Electron Device Letters,* 2006, vol. 27 (2), 120-122

- **Colinge, J.P. ; Xiong, W. ; Cleavelin, C.R. ; Schulz, T. ; Schrüfer, K. ; Matthews, K. ; Patruno, P.** Room-Temperature Low-Dimensional Effects in Pi-Gate SOI MOSFETs. *Electron Device Letters, IEEE,* 2006, vol. 27 (9), 775-777
- **X. Tang ; X. Baie ; J.P. Colinge ; F. Van de Wiele ; V. Bayot.** *Electrochemical Society Proceedings,* 2001, vol. 2001-3, 415
- **J.P. Colinge ; J. C. Alderman ; W. Xiong ; C. R. Cleavelin.** *IEEE Transactions on Electron Devices,* 2006, vol. 53-5, 1131
- **Chi-Woo Lee ; Se-Re-Na Yun ; Chong-Gun Yu ; Jong-Tae Park ; J.P. Colinge.** *Solid-State Electronics,* 2007, vol. 51-3, 505
- **J. P. Colinge ; X. Baie ; V. Bayot.** *IEEE Electron Device Letters,* 1994, vol. 15-6, 193